# EUROPEAN PATENT SPECIFICATION

(11) **EP 3 553 534 B1**
(45) Date of publication and mention of the grant of the patent: **10.07.2024**
(21) Application number: 18167293.2
(22) Date of filing: 13.04.2018
(51) Int. Cl.: G01R 1/04, G01R 31/28, G01R 3/00

(54) **TESTING APPARATUS FOR SINGULATED SEMICONDUCTOR DIES WITH SLIDING LAYER**
TESTVORRICHTUNG FÜR VEREINZELTE HALBLEITER-DIES MIT GLEITSCHICHT
APPAREIL D'ESSAI POUR PUCES DE SEMI-CONDUCTEURS SINGULARISÉES AVEC UNE COUCHE DE GLISSEMENT

(43) Date of publication of application: 16.10.2019
(73) Proprietor: ams AG, 8141 Premstätten (AT)
(72) Inventor: Reith, Christoph, 8302 Nestelbach bei Graz (AT)
(74) Representative: Epping - Hermann - Fischer

(56) References cited:
- WO-A1-2009/153032
- WO-A2-2017/007200
- JP-A- 2002 164 136
- JP-A- H09 178 806
- US-A1- 2007 224 867
- US-A1- 2010 132 736
- US-A1- 2016 320 428
- US-A1- 2018 188 290

## Description

The present invention relates to a testing device for singulated semiconductor dies and the alignment of electric contact elements of the dies with respect to electric contact elements of the testing device.

Testing bare silicon dies involves placing the contact elements of the dies (like solder balls, for instance) on contact elements of a testing device (like pogo pins, for instance). The silicon dies are usually dropped into the testing device nest via a chamfered opening. Then the silicon dies can be positioned by sliding them on a sliding surface, until the corresponding contact elements are connected to one another and allow a voltage or current to be applied to the dies through the testing device. The alignment is achieved by means of a pushing device, which may include at least two push pin devices acting in different directions.

JP 2002 164136 A discloses a socket for integrated circuits (IC) of ball-grid-array (BGA) type. A device under test (DUT) is arranged on a top plate. Positioning of the DUT is performed in order to establish a contact between a solder ball of the DUT and a probe pin of the socket for measuring the electrical characteristics of the DUT. Positioning is achieved by four adjusting members, which are arranged so as to surround the four sides of the DUT. The correct position is confirmed by four pairs of photo sensors located at the four corners of the DUT.

WO 2017/007200 A2 discloses a test socket manufacturing method comprising preparing a printed circuit board (PCB), on which a bonding pad is disposed, bonding a conductive wire on the bonding pad, mounting, on an upper surface of the PCB, a space, through which the bonding pad is exposed, mounting, on a upper surface of the base, a jig which covers the bonding pad, and injecting liquid silicone rubber into a jig assembly by using the jig assembly as a mold, the jig assembly including the PCB, the space, the base, and the jig.

WO 2009/153032 A1 discloses a contacting device for contacting electronic components, in particular ICs, with contact springs of a contact socket, a strip cleaning equipment comprising a strip moving mechanism and a cleaning strip which is guided over the contact springs of the contact socket. The cleaning strip has at least one recess through which a component can be guided and at least one cleaning region which is provided with an adhesive layer on its side facing the contact springs.

US 2010/132736 A1 discloses a test cell conditioner (TCC) surrogate cleaning device for cleaning the pin elements in a socket or electrical interface receptacle of a load board including a main testing frame, a plurality of trays, testing chip receptacles and one or more pick up devices. Chips to be tested are entrained on a tray, and a plurality of adhesive cleaning chips are entrained on another tray. The adhesive cleaning chip contains a solid layer and an adhesive layer, and an abrasive material is mingled in the adhesive layer. The pick up device removes the adhesive cleaning chip to a position above the testing chip receptacle and cleans up the oxides and other foreign materials sticking on the receptacle by absorption or abrasion.

JP H09 178806 A discloses a method for removing foreign matters stuck to a semiconductor device manufacturing jig assembling a resin package sealing a semiconductor chip and a semiconductor device having multiple outer lead sections. A foreign matter removing sheet is pinched between a jig main body having a connector section to be kept in contact with the semiconductor device and a cover member. The foreign matters stuck to the jig main body adhere to the foreign matter removing sheet.

US 2007/224867 A1 discloses a test and burn-in socket for BGA type devices. The socket is an open top device in that there is no contact on the upper surface of the DUT. The test and burn-in socket further features dual contacts for simultaneous voltage and current measurements. The socket additionally provides that the dual contacts serve as a latching mechanism to hold the device in place throughout the test and burn-in process.

US 2016/320428 A1 discloses a latch assembly that can lock and unlock a probe core with respect to a circuit board. The latch assembly can engage with the probe core to align the probe core with respect to a circuit board, and press down the probe core against the circuit board by rotating to lock the probe core with the circuit board. An installation tool is provided to grip or release the probe core to/from a latch assembly or a probe core carrier. The installation tool can align with the probe core and/or the latch assembly to lock and unlock the probe core with respect to a circuit board.

It is an object of the present invention to provide a testing apparatus for semiconductor dies, which facilitates the arrangement of the dies in the testing device nest for a proper alignment of corresponding contact elements.

This object is achieved with the testing apparatus for semiconductor dies according to claim 1. Embodiments derive from the dependent claims.

The definitions as described above also apply to the following description unless stated otherwise.

The testing apparatus for semiconductor dies comprises a nesting frame and a bottom part, which form a testing device nest adapted to the size of a semiconductor die. A pushing device is provided for an alignment of the semiconductor die in the testing device nest. An engineering plastic layer on the bottom part forms a surface on which the semiconductor die slides during its alignment.

An embodiment of the testing apparatus further comprises a clean-out die with a polymer layer. The clean-out die is movable such that the polymer layer wipes the engineering plastic layer.

A further embodiment comprises contact elements of the testing device nest, which are reversibly movable to a position where they touch the polymer layer. The bottom part may be recessed for the contact elements. The contact elements can be pogo pins, for instance.

In further embodiments the bottom part is recessed in a keep out zone that is provided for contact elements and/or a redistribution layer of the semiconductor die.

According to the invention a ledge in the nesting frame forms an accommodation region for burr that is present at a lateral surface or edge of the semiconductor die.

In a further embodiment the surface on which the semiconductor die slides during its alignment has a linear dimension of 200 µm or less in a direction of sliding.

The testing device nest may especially be adapted to the alignment of singulated wafer-level chip-scale packages.

The following is a detailed description of examples of the testing apparatus in conjunction with the appended figures, which are not drawn to scale.
- Figure 1: is a cross section of an embodiment of the testing apparatus with an inserted semiconductor die.
- Figure 2: is a cross section of a further embodiment of the testing apparatus with an inserted semiconductor die during the alignment process.
- Figure 3: is a cross section according to Figure 2 with the semiconductor die in aligned position and contacted by e. g. pogo pins.
- Figure 4: is a cross section of the further embodiment of the testing apparatus with an inserted clean-out die during the alignment process.
- Figure 5: is a cross section according to Figure 4 with the clean-out die in aligned position and contacted by e. g. pogo pins.

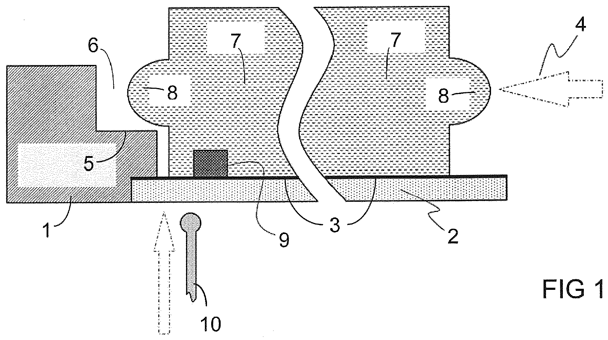

Figure 1 is a cross section of an embodiment of the testing apparatus. A testing device nest accommodates a semiconductor die 7 during a test and is formed by a nesting frame 1 and a bottom part 2, which is covered with an engineering plastic layer 3. A pushing device 4 for the alignment of the semiconductor die 7 may be configured as in conventional testing devices and is therefore only schematically indicated in Figure 1. The pushing device 4 may especially comprise at least two push pin devices acting in different directions, for example.

The engineering plastic layer 3 is smooth and provides an enhanced sliding surface, on which the semiconductor die 7 easily slides during its alignment. In particular if a redistribution layer (RDL) is present on the bottom surface of the semiconductor die 7, the engineering plastic layer 3 is optionally provided with a cut out area. The smooth sliding surface prevents damage to the redistribution layer. Moreover, the engineering plastic can be configured to collect silicon dust/grit for later removal by a device comprising a sticky material or adhesive.

A ledge 5 is present in the nesting frame 1 to form an accommodation region 6 for protruding burr 8 that is present at a lateral surface or edge of the semiconductor die 7. The accommodation region 6 allows a precise alignment of the semiconductor die 7 within the testing device nest, irrespective of the size and shape of the burr 8, and the engineering plastic layer 3 can be employed to its full advantage.

The semiconductor die 7 is typically provided with contact elements 9, which may in particular be solder balls or bump contacts, for instance. Contact elements 10 of the testing device nest are arranged in such a manner that they extend sufficiently far into the testing device nest to be able to contact the contact elements 9 of the semiconductor device 7. The arrangement of the contact elements 10 of the testing device nest may be similar to an arrangement of contact elements in a conventional testing device.

The contact elements 10 of the testing device nest can comprise movable parts or components and can especially be formed by pogo pins, for instance. It may be advantageous if the entire contact elements 10 are normally arranged outside the testing device nest. When a semiconductor die 7 is to be tested, the contact elements 10 are reversibly moved into a position in which they extend sufficiently far into the testing device nest. Such a movement is indicated in Figure 1 by the vertical arrow.

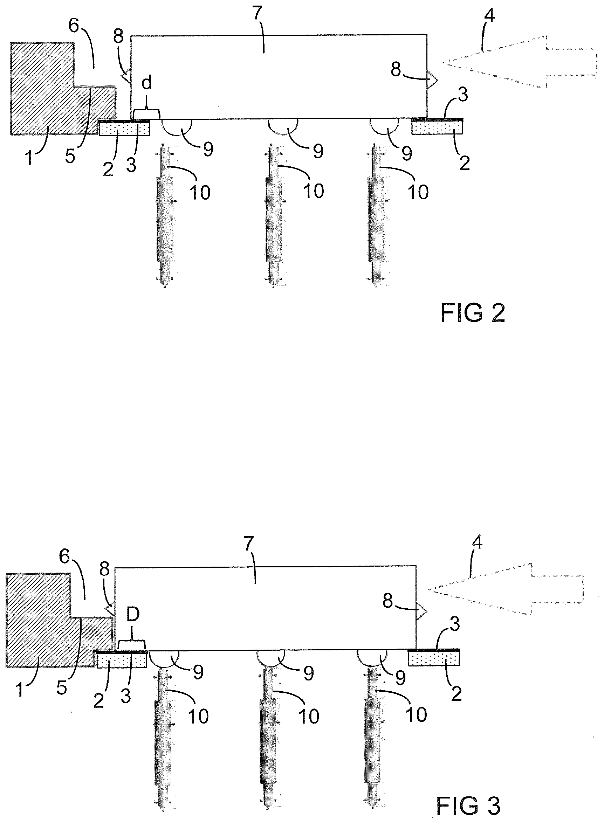

Figure 2 is a cross section of a further embodiment of the testing apparatus. The elements of the embodiment according to Figure 2 that correspond to elements of the embodiment according to Figure 1 are designated with the same reference numerals. Figure 2 shows the semiconductor die 7 in a position where it is not yet aligned, and the corresponding contact elements 9, 10 are not in contact with each other. The contact elements 10 of the testing device nest are illustrated as pogo pins, but other types of contact elements may be appropriate as well.

In the embodiment according to Figure 2, the bottom part 2 is recessed to provide free space for a lateral shift of the protruding solder balls which form the contact elements 9 of the semiconductor die 7. The distance d between the lateral surface or edge of the semiconductor die 7 and the outermost solder ball can typically be about 200 pm, which suffices for the alignment of the semiconductor die 7 inside the testing device nest.

Figure 3 is a cross section according to Figure 2 with the semiconductor die in aligned and contacted position. Figure 2 and Figure 3 show how the contact elements 9 of the semiconductor die 7 shift within the recess of the bottom part 2 until they are precisely opposite the contact elements 10 of the testing device nest. The contact elements 9, 10 are brought into contact by a vertical shift of the contact elements 10 of the testing device nest.

In the embodiment according to Figures 2 and 3, only part of the bottom of the semiconductor die 7 is in contact with the engineering plastic layer 3. The surface on which the semiconductor die 7 slides may have a linear dimension D of typically 200 µm or less in the direction of sliding. The linear dimension D may in particular be smaller than the distance d between the lateral surface or edge of the semiconductor die 7 and the outermost protruding contact element 9. Friction is thus reduced to facilitate the sliding process. Moreover, if RDL traces are present on the bottom of the semiconductor die 7, the recess of the bottom part 2 provides a keep out zone and prevents the RDL traces from damage.

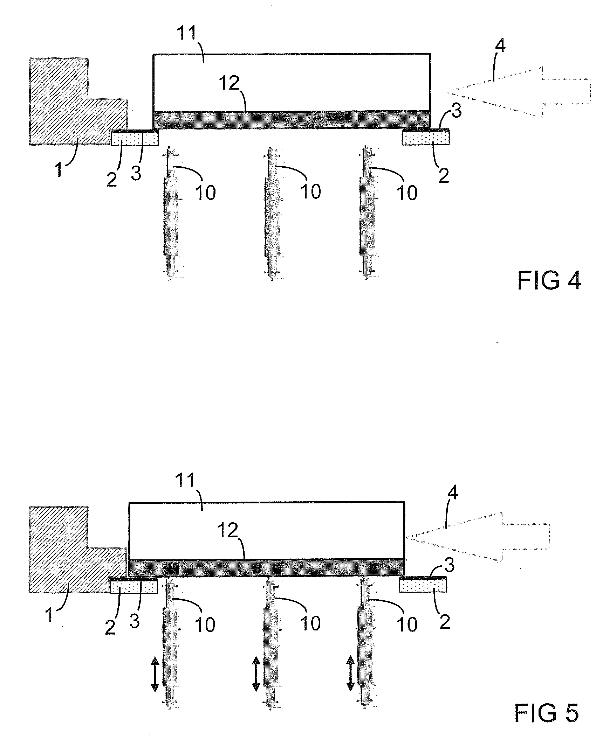

Figure 4 is a further cross section of the embodiment according to Figure 2 with an inserted clean-out die 11. The clean-out die 11 serves to collect any silicon dust from the engineering plastic layer 3. The contact elements 10 of the testing device nest may also be cleaned by means of the clean-out die 11. Figure 4 shows the clean-out die 7 in a position where it is not yet aligned. The pushing device 4 is used to align the clean-out die 11 inside the testing device nest.

The clean-out die 11 can be made of pure silicon, which is overmolded with a kind of polymer. The polymer layer 12 has adhesive properties and collects silicon dust or grit. During a test of a semiconductor die, the clean-out die 11 stays in a dedicated position outside the testing device nest ("parking position"). After the test of the semiconductor die 7 or after a predefined number of tests or test cycles, which can be set in advance, the clean-out die 11 is inserted in the testing device nest for the purpose of cleaning.

Figure 5 is a cross section according to Figure 4 with the clean-out die 11 in aligned position, in which the entire sliding surface provided by the engineering plastic layer 3 is in contact with the polymer layer 12 and is thus cleaned. The contact elements 10 can be cleaned by repeatedly pushing them into the polymer layer 12. The movement of the contact elements 10 for cleaning is indicated in Figure 5 by the vertical double arrows.

The described testing apparatus facilitates the alignment of semiconductor dies in a testing device nest and allows easy cleaning of the testing device nest. These advantages are not obtained with conventional testing devices. The described testing apparatus is in particular suitable for the alignment of singulated wafer-level chip-scale packages.

### List of reference numerals

- 1: nesting frame
- 2: bottom part
- 3: engineering plastic layer
- 4: pushing device
- 5: ledge
- 6: accommodation region
- 7: semiconductor die
- 8: burr
- 9: contact element of the semiconductor die
- 10: contact element of the testing device nest
- 11: clean-out die
- 12: polymer layer
- d: distance
- D: linear dimension

## Claims

1. A testing apparatus for singulated semiconductor dies, comprising:
a nesting frame (1) and a bottom part (2), which form a testing device nest adapted to the size of a semiconductor die (7), and
a pushing device (4) for an alignment of the semiconductor die (7) in the testing device nest,
**characterized in that**
an engineering plastic layer (3) on the bottom part (2) forms a smooth sliding surface on which the semiconductor die (7) slides during its alignment, and
the testing apparatus further comprises
a ledge (5) in a sidewall of the nesting frame (1), wherein, when the semiconductor die (7) is pushed against the sidewall of the nesting frame (1) by the pushing device (4), the ledge (5) forms an accommodation region (6) for a burr (8) that is present at a lateral surface or edge of the semiconductor die (7) .

2. The testing apparatus of claim 1, further comprising:
a clean-out die (11) with a polymer layer (12), the clean-out die (11) being movable such that the polymer layer (12) wipes the engineering plastic layer (3).

3. The testing apparatus of claim 2, further comprising:
contact elements (10) of the testing device nest, which are reversibly movable to a position where they touch the polymer layer (12).

4. The testing apparatus of claim 3, wherein the bottom part (2) is recessed for the contact elements (10).

5. The testing apparatus of claim 3 or 4, wherein the contact elements (10) are pogo pins.

6. The testing apparatus of one of claims 1 to 5, wherein the bottom part (2) is recessed in a keep out zone that is provided for contact elements (9) and/or a redistribution layer of the semiconductor die (7).

7. The testing apparatus of one of claims 1 to 6, wherein the surface on which the semiconductor die (7) slides during its alignment has a linear dimension (D) of 200 µm or less in a direction of sliding.

8. The testing apparatus of one of claims 1 to 7, wherein the testing device nest is adapted to the alignment of singulated wafer-level chip-scale packages.

## Patentansprüche

1. Prüfvorrichtung für vereinzelte Halbleiter-Dies, umfassend:
einen Aufnahmerahmen (1) und ein Bodenteil (2), die eine an die Größe eines Halbleiter-Dies (7) angepasste Prüfvorrichtungsaufnahme bilden, und
eine Schiebevorrichtung (4) zum Ausrichten des Halbleiter-Dies (7) in der Prüfvorrichtungsaufnahme,
**dadurch gekennzeichnet, dass**
eine technische Kunststoffschicht (3) auf dem Bodenteil (2) eine glatte Gleitfläche bildet, auf der das Halbleiter-Die (7) während seiner Ausrichtung gleitet, und
die Prüfvorrichtung ferner eine Leiste (5) in einer Seitenwand des Aufnahmerahmens (1) umfasst, wobei, wenn das Halbleiter-Die (7) durch die Schiebevorrichtung (4) gegen die Seitenwand des Aufnahmerahmens (1) geschoben wird, die Leiste (5) einen Aufnahmebereich (6) für einen Grat (8) bildet, der an einer Seitenfläche oder Kante des Halbleiter-Dies (7) vorhanden ist.

2. Die Prüfvorrichtung nach Anspruch 1, ferner umfassend:
eine Reinigungs-Die (11) mit einer Polymerschicht (12), wobei das Reinigungs-Die (11) so beweglich ist, dass die Polymerschicht (12) die technische Kunststoffschicht (3) abwischt.

3. Die Prüfvorrichtung nach Anspruch 2 ferner umfassend:
Kontaktelemente (10) der Prüfvorrichtungsaufnahme, die reversibel in eine Position bewegbar sind, in der sie die Polymerschicht (12) berühren.

4. Prüfvorrichtung nach Anspruch 3, wobei das Bodenteil (2) eine Ausnehmung für die Kontaktelemente (10) aufweist.

5. Prüfvorrichtung nach Anspruch 3 oder 4, wobei die Kontaktelemente (10) Pogo-Pins sind.

6. Prüfvorrichtung nach einem der Ansprüche 1 bis 5, wobei das Bodenteil (2) in einer Aussparungszone , die für Kontaktelemente (9) und/oder eine Umverteilungsschicht des Halbleiter-Dies (7) vorgesehen ist, ausgenommen ist.

7. Prüfvorrichtung nach einem der Ansprüche 1 bis 6, wobei die Oberfläche, auf der das Halbleiter-Die (7) während seiner Ausrichtung gleitet, eine lineare Abmessung (D) von 200 µm oder weniger in einer Gleitrichtung aufweist.

8. Die Prüfvorrichtung nach einem der Ansprüche 1 bis 7, wobei die Prüfvorrichtungsaufnahme an die Ausrichtung von vereinzelten Wafer-Level-Chip-Scale-Packages angepasst ist.

## Revendications

1. Appareil d'essai pour des puces à semi-conducteur singulées, comprenant:
un cadre d'emboîtement (1) et une partie inférieure (2), qui forment un emboîtement du dispositif d'essai adapté à la taille d'une puce à semi-conducteur (7), et
un dispositif de poussée (4) pour l'alignement de la puce à semi-conducteur (7) dans l'emboîtement du dispositif d'essai,
**caractérisé en ce que**
une couche de plastique technique (3) sur la partie inférieure (2) forme une surface de glissement lisse sur laquelle la puce à semi-conducteur (7) glisse pendant son alignement, et
l'appareil d'essai comprend en outre un rebord (5) dans une paroi latérale du cadre d'emboîtement (1), dans lequel,
lorsque la puce à semi-conducteur (7) est poussé contre la paroi latérale du cadre d'emboîtement (1) par le dispositif de poussée (4), le rebord (5) forme une région de logement (6) pour une bavure (8) présente à une surface latérale ou un bord de la puce à semi-conducteur (7).

2. L'appareil d'essai selon la revendication 1, comprenant en outre:
une puce de nettoyage (11) avec une couche de polymère (12), la puce de nettoyage (11) étant mobile de sorte que la couche de polymère (12) essuie la couche de plastique technique (3).

3. L'appareil d'essai selon la revendication 2, comprenant en outre:
des éléments de contact (10) du emboîtement du dispositif d'essai, qui peuvent être déplacés de manière réversible dans une position où ils touchent la couche de polymère (12).

4. L'appareil d'essai selon la revendication 3, dans lequel la partie inférieure (2) est évidée pour les éléments de contact (10).

5. L'appareil d'essai selon la revendication 3 ou 4, dans lequel les éléments de contact (10) sont des broches pogo.

6. L'appareil d'essai selon l'une des revendications 1 à 5, dans lequel la partie inférieure (2) est évidée dans une zone d'exclusion prévue pour les éléments de contact (9) et/ou une couche de redistribution de la puce à semi-conducteur (7).

7. L'appareil d'essai selon l'une des revendications 1 à 6, dans lequel la surface sur laquelle la puce à semi-conducteur (7) glisse pendant son alignement a une dimension linéaire (D) de 200 µm ou moins dans une direction de glissement.

8. L'appareil d'essai selon l'une des revendications 1 à 7, dans lequel l'emboîtement du dispositif d'essai est adapté à l'alignement de boîtiers singulés à puce sur tranche.
